(19) Europäisches Patentamt
European Patent Office
Office européen des brevets

(11) **EP 3 275 065 B1**

(12) **EUROPÄISCHE PATENTSCHRIFT**

(45) Veröffentlichungstag und Bekanntmachung des Hinweises auf die Patenterteilung:
**20.01.2021 Patentblatt 2021/03**

(21) Anmeldenummer: **16705514.4**

(22) Anmeldetag: **19.02.2016**

(51) Int Cl.:
*H02H 3/08* *(2006.01)*      *H02H 3/00* *(2006.01)*

(86) Internationale Anmeldenummer:
**PCT/EP2016/053529**

(87) Internationale Veröffentlichungsnummer:
**WO 2016/150628 (29.09.2016 Gazette 2016/39)**

(54) **SCHUTZANORDNUNG**

PROTECTIVE ARRANGEMENT

DISPOSITIF DE PROTECTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2015 DE 102015104623**

(43) Veröffentlichungstag der Anmeldung:
**31.01.2018 Patentblatt 2018/05**

(73) Patentinhaber: **Phoenix Contact GmbH & Co. KG 32825 Blomberg (DE)**

(72) Erfinder:
- **KNOOP, Daniel**
  **33102 Paderborn (DE)**
- **ALSDORF, Lars**
  **59494 Soest (DE)**

(74) Vertreter: **Patentship Patentanwaltsgesellschaft mbH Elsenheimerstraße 65 80687 München (DE)**

(56) Entgegenhaltungen:
**DE-A1- 19 811 956      DE-A1-102007 013 551 US-A1- 2013 066 478**

**Beschreibung**

Die Erfindung betrifft eine Schutzanordnung zum Schutz von elektrischen Geräten vor Überstrom nach dem Oberbegriff des Anspruchs 1.

Eine gattungsgemäße Schutzanordnung weist einen Eingang auf, an dem der Schutzanordnung von einer Stromversorgung ein Strom zugeführt wird, sowie einen Ausgang, über den der Strom als Ausgangsstrom an das zu schützende elektrische Gerät zu dessen Versorgung weitergeleitet wird. Dabei weist die Schutzanordnung in der Stromleitung zwischen dem Eingang und dem Ausgang eine Sicherung auf, die zum Schutz des Gerätes vor Überstrom beim Überschreiten eines voreingestellten Auslösestroms die Stromleitung vom Eingang zum Ausgang unterbricht.

Aus der DE 20 2004 014 589 U1 ist ein elektronischer Schutzschalter mit einstellbarer Auslösecharakteristik bekannt, der bei erhöhter Stromaufnahme einen Auslöse- bzw. Ausschaltvorgang auslöst. Dabei wird in Absatz 34 der DE 20 2004 014 589 U1 beschreiben, dass die Eingabe und Auswahl der gewünschten Auslöse-Charakteristika über eine Mensch-Maschine-Schnittstelle erfolgen kann.

Die Druckschrift US 2013 / 0 066 478 A1 betrifft ein Verfahren zum Einstellen und Anpassen von Auslöseeinstellungen für einen Leistungsschalter durch Überwachung der Kurzschlussstromverfügbarkeit (SCCA) und Anpassung der Auslöseeinstellungen basierend auf empfangenen SCCA-Schätzwerten. Eine Steuerung ist ausgebildet, auf Grundlage der SCCA-Schätzwerte die Auslöseeinstellungen für den Leistungsschalter zu ändern. Abhängig von der entsprechenden Kurzschlussstromverfügbarkeit passt die Steuerung die Kurzschlussauslöseeinstellungen für den Leistungsschalter in Echtzeit an, sodass diese unter dem SCCA-Wert liegen.

Die Druckschrift DE 10 2007 013 551 A1 betrifft ein Verfahren zum selbsttätigen Einstellen eines Schutzgerätes mit einem einen Überstromauslöser. Das Schutzgerät ist ausgebildet, sowohl einen Verbraucher vor einer Überlast als auch eine Energieverteilungsanlage vor einem Kurzschluss zu schützen. An dem Überstromauslöser ist als Parameter zumindest eine Auslösezeit einzustellen, die sicherstellt, dass keine thermische Überlastung des Verbrauchers auftritt. Um eine selbsttätige Einstellung des Überstromauslösers zu ermöglichen, kann anhand des zeitlichen Motorstromverlaufs des Verbrauchers bei vorgegebener Belastung, die Auslösezeit des Überstromauslösers abgeleitet werden.

Die Druckschrift DE 198 11 956 A1 offenbart einen elektronischen Auslöser, insbesondere für Niederspannungs-Leistungsschalter, mit Einstell- und Anzeigeelementen für die einzustellenden Auslöseparameter, wie für den Auslösestrom bei Überlast und die zugehörige Verzögerungszeit. Die Schalt- und Anzeigeelemente wirken mit Einstellvorrichtungen für die Parameter zusammen und die Einstell- und Anzeigeelemente sind an einer Bedienungsfront des Auslösers angeordnet. Als Einstell- und Anzeigeelemente sind Tastenschalter und LCD-Elemente vorgesehen. Die einstellbaren Parameter des Auslösers können in vier Gruppen gegliedert sein: langzeitverzögerte Auslösung, unverzögerte Auslösung, kurzzeitverzögerte Auslösung und Erdschlussauslösung mit Verzögerung. Grundlage der Einstellung ist ein Prozentsatz des Stromwandler-Nennstromes.

Die Einstellung der Auslöse-Charakteristika, insbesondere des Auslösestroms, an die betriebsgemäß unterschiedlichen Versorgungsströme der anzuschließenden elektrischen Geräte ist häufig problematisch. Falls der eingestellte Wert für den Auslösestrom zu groß ist, kann ein angeschlossenes Gerät nicht sicher vor einer Überbelastung geschützt werden, da selbst dann, wenn der aktuelle Strom den typischen Verbrauchsstrom (Nennstrom) des angeschlossenen Gerätes signifikant überschreitet, die Sicherung nicht auslöst.

Aufgabe der Erfindung ist es daher, eine Schutzanordnung zu schaffen, die eine optimale Einstellung des Auslösestroms ermöglicht, so dass die Schutzanordnung einerseits hinreichend empfindlich ist, um das angeschlossene Gerät sicher zu schützen und andererseits nicht zu empfindlich ist, um in unkritischen Fällen Fehlabschaltungen zu vermeiden.

Diese Aufgabe wird durch die Merkmale des Anspruchs 1 gelöst. Vorteilhafte Weiterbildungen sind den abhängigen Ansprüchen zu entnehmen.

Dabei weist die Schutzanordnung einen Stromsensor auf, der den Strom in der Stromleitung bei angeschlossenem Gerät misst, wobei der Auslösestrom für den Schutzschalter in Abhängigkeit vom gemessenen Strom auf einen Wert einstellbar ist, der um eine Differenz größer ist als der gemessene Strom.

Hierzu weist die Schutzanordnung vorzugsweise eine Auswerte- und Steuereinheit auf, der der gemessene Strom zugeführt wird, wobei die Auswerte- und Steuereinheit anhand des gemessenen Stroms automatisch den Wert für den Auslösestrom einstellt.

Auf diese Weise wird der Auslösestrom optimal an den aktuell fließenden Verbrauchsstrom des angeschlossenen Gerätes angepasst, indem für den Auslösestrom ein Wert einstellbar ist, der dem aktuell fließenden Gerätestrom plus einer Differenz entspricht, wobei für die Differenz beispielsweise ein Wert von 25% des jeweils fließenden Gerätestrom verwendet wird.

Erfindungsgemäß wird eine Lösung für die Weiterbildung von bestehenden Schutzanordnungen angegeben, die über eine manuelle Einstellmöglichkeit für den Auslösestrom des Schutzschalters verfügen und diese manuelle Einstellmöglichkeit auch weiterhin Bestandteil der Schutzanordnung sein soll. Erfindungsgemäß weist die Schutzanordnung zusätzlich zu dem manuellen Einstellmittel, mit dem in einem Einstellmodus der Auslösestrom zwischen einem oberen und einem unteren Wert stufenweise oder stufenlos erniedrigt oder erhöht werden kann, ein optisches und/oder akustisches Rückmeldesignalmittel auf. Dabei gibt das Rückmeldesignalmittel dem Benutzter mit einer ersten Signalform eine Rückmeldung darüber, ob ein anhand des jeweils eingestellten Wertes für den Auslösestrom bestimmter Schwellwert größer ist als der über den Stromsensor gemessene Strom, während es dem Benutzer mit einer zweiten, von der ersten verschiedenen Signalform eine Rückmeldung darüber gibt, ob der anhand des jeweils eingestellten Wertes für den Auslösestrom bestimmte Schwellwert kleiner ist als der gemessene Strom. Auf diese Weise kann der Benutzer über das manuelle Einstellmittel und unter Berücksichtigung der Rückmeldesignale iterativ einen optimalen Auslösestrom auswählen. Der so ausgewählte Auslösestrom kann dann vorzugsweise vom Benutzer über ein Bestätigungsmittel, z.B. ein Taster, zur Verwendung im Arbeitsmodus bestätigt werden. Der Schwellwert kann dabei dem Auslösestrom multipliziert mit einem Faktor, vorzugsweise kleiner 1, entsprechen. Der Schwellwert kann auch unmittelbar dem jeweils eingestellten Auslösestrom entsprechen.

Der der Erfindung zugrunde liegende Gedanke soll nachfolgend anhand der in den Figuren gezeigten Ausführungsbeispiele näher erläutert werden. Es zeigen:

Fig. 1      eine schematische Darstellung der Schutzanordnung mit vorgeschalteter Stromversorgung und zu schützendem Gerät,

Fig. 2      ein Blockschaltbild der Schutzanordnung,

Fig. 3      ein Blockschaltbild der Schutzanordnung in der Ausführungsform mit Einstellmittel, Rückmeldesignalmittel und Bestätigungsmittel,

Fig. 4      eine Ausführungsform der Schutzanordnung gemäß Figur 3,

Fig. 5 + 6      Diagramme zur Veranschaulichung der manuellen, stufenweisen Einstellung des Auslösestroms,

Fig. 7      ein Diagramm zur Veranschaulichung der manuellen, stufenlosen Einstellung des Auslösestroms,

Fig. 8      ein Flussdiagramm zur Veranschaulichung der Einstellung des Auslösestroms,

Fig. 9      eine Draufsicht auf eine Frontblende einer erfindungsgemäßen Schutzanordnung,

Fig. 10      die Verteilung eines Sammelstroms auf 8 verschiedene erfindungsgemäß ausgebildete Kanäle.

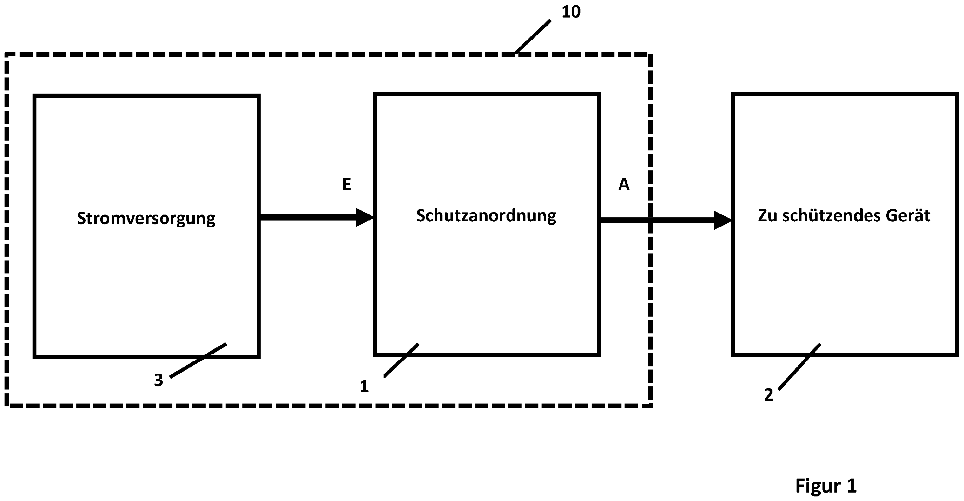

Figur 1 zeigt eine schematische Darstellung einer Schutzanordnung (1) mit vorgeschalteter Stromversorgung (3) und einem angeschlossenen und zu schützenden Gerät (2). Der Schutzanordnung (1) wird an einem Eingang (E) der von der Stromversorgung (3) gelieferte Strom zugeführt. Nach Durchleitung durch die Schutzanordnung (2) verlässt dieser Strom am Ausgang (A) als Ausgangsstrom die Schutzanordnung (2) und wird an das zu versorgende und zu schützende Gerät (2) weitergeleitet. Bei dem elektrischen Gerät kann es sich um jede Art von elektrischem Verbraucher handeln, bspw. ein Motor etc.

Die Stromversorgung (3) und die Schutzanordnung (1) können als separate Baueinheiten mit jeweils einem eigenen Gehäuse ausgebildet sein, die beispielsweise innerhalb eines Schaltschranks auf eine Tragschiene, insbesondere eine Hutschiene gerastet werden. Es ist jedoch auch vorgesehen, die Stromversorgung (3) und die Schutzanordnung (1) in einer Baueinheit (10) zu integrieren, die wiederum auf einer Tragschiene angeordnet werden kann.

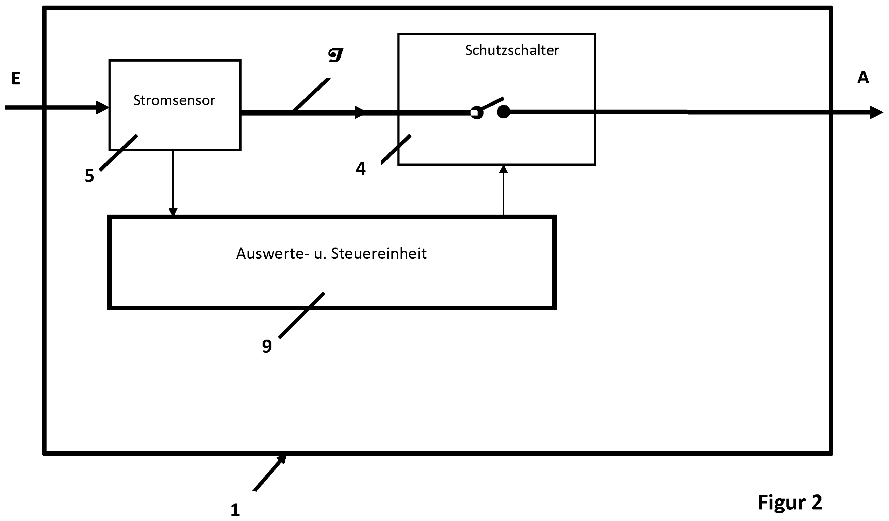

Figur 2 zeigt ein Blockschaltbild einer Schutzanordnung (1), die in der Stromleitung zwischen dem Eingang (E) und dem Ausgang (A) einen Stromsensor (5) aufweist. Der Stromsensor (5) misst bei angeschlossenem Gerät (2) den Strom ($I_{Ist}$) in der Stromleitung. Ferner weist die Schutzanordnung (1) einen Schutzschalter (4) auf. Dabei wird der Auslösestrom für den Schutzschalter (4) in Abhängigkeit vom gemessenen Strom ($I_{Ist}$) auf einen Wert eingestellt, der um eine Differenz größer ist als der gemessene Strom:

$$I_{Auslösestrom} = I_{Ist} + \Delta I.$$

Dazu weist die Schutzanordnung (1) vorzugsweise eine Auswerte- und Steuereinheit (9) auf, der der gemessene Strom ($I_{Ist}$) zugeführt wird, wobei die Auswerte- und Steuereinheit (9) anhand des gemessenen Stroms ($I_{Ist}$) automatisch den Wert für den Auslösestrom berechnet und dann, wenn der gemessene Strom ($I_{Ist}$) den Auslösestrom überschreitet, ein Auslösesignal an den Schutzschalter (4) schickt.

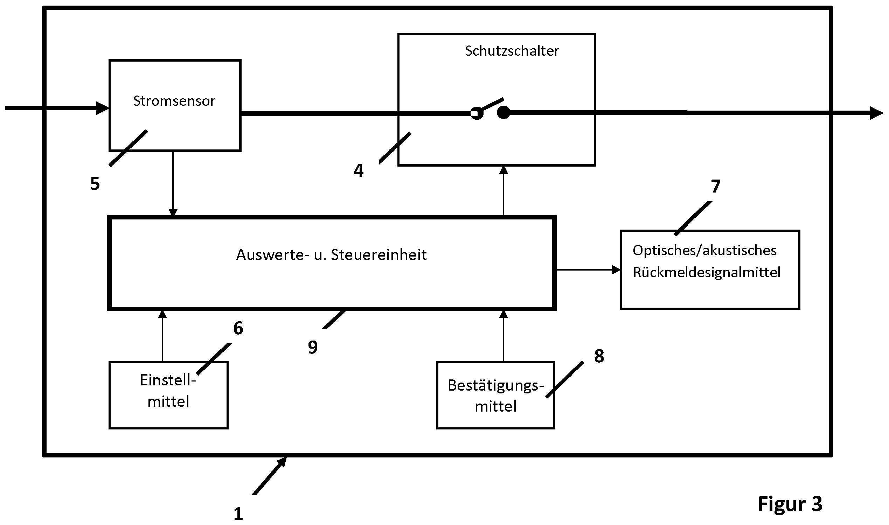

Fig. 3 zeigt ein Blockschaltbild der Schutzanordnung (1) in der Ausführungsform mit einem manuell betätigbaren Einstellmittel (6), einem optischen und/oder akustischen Rückmeldesignalmittel (7) und einem manuell betätigbaren Bestätigungsmittel (8). Über das Einstellmittel (6) ist der Benutzer in der Lage, in einem Einstellmodus den Auslösestrom zwischen einem oberen und einem unteren Wert stufenweise oder stufenlos zu erniedrigen oder zu erhöhen. Das Rückmeldesignalmittel (7) gibt dem Benutzer mit einer ersten Signalform eine Rückmeldung darüber, ob der jeweils anhand des eingestellten Wertes für den Auslösestrom bestimmte Schwellwert größer ist als der gemessene Strom ($I_{Ist}$), während es dem Benutzer mit einer zweiten, von der ersten verschiedenen Signalform eine Rückmeldung darüber gibt, ob der jeweils anhand des eingestellten Wert für den Auslösestrom bestimmte Schwellwert kleiner ist als der gemessene Strom ($\mathcal{I}$Ist). Mit dem Bestätigungsmittel (8) kann ein ausgewählter Wert für den Auslösestrom zur Verwendung im Arbeitsmodus vom Benutzer bestätigt werden. Das Bestätigungsmittel (8) ist nicht zwingend erforderlich, jedoch vorteilhaft.

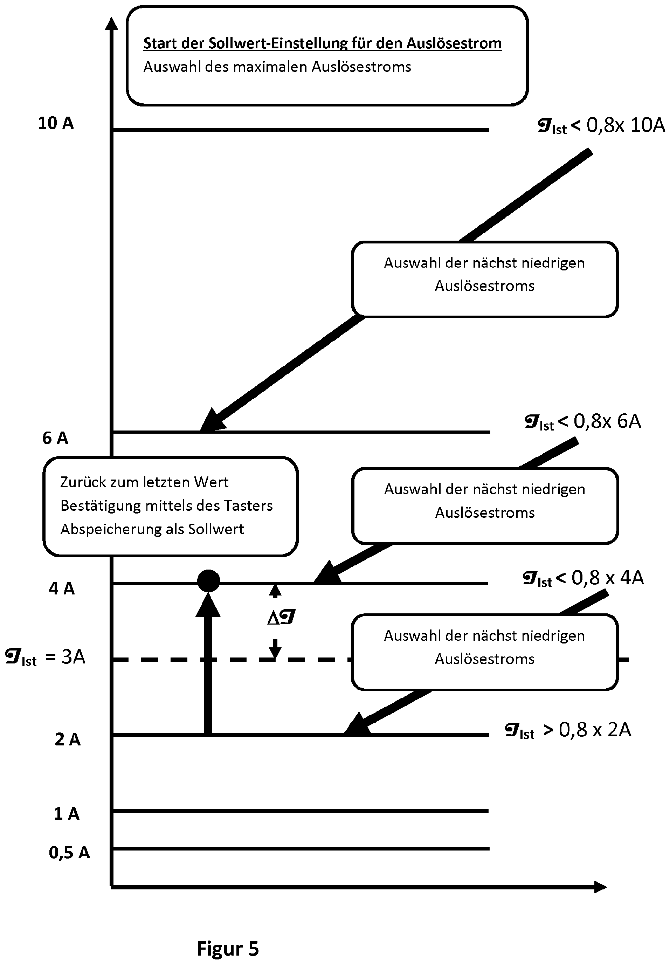

Die Einstellung des optimalen Auslösestrom wird anhand von Figur 5 erläutert. Das Rückmeldesignalmittel (7) gibt jeweils mit einer ersten Signalform eine Rückmeldung darüber, wenn der gemessene Strom ($\mathcal{I}$Ist) kleiner als bspw. 80% des eingestellten Auslösestrom ist, d.h. der Auslösestrom um mindestens 25% größer ist als der gemessene Strom. Ferner gibt das Rückmeldesignalmittel (7) jeweils mit einer zweiten Signalform eine Rückmeldung darüber, wenn der gemessene Strom ($\mathcal{I}$Ist) größer als 80% des eingestellten Auslösestrom ist. Im vorliegenden Beispiel beträgt die Differenz $\Delta\mathcal{I}$ somit 25% des aktuell fließenden Stroms.

In diesem Beispiel wird ein Einstellmittel (6) verwendet, das eine stufenweise Einstellung des Auslösestrom ermöglicht. Der aktuell fließende und mit dem Stromsensor (5) gemessene Strom sei 3 A. Für den Start der Sollwert-Einstellung für den Auslösestrom wird z.B. ein oberer Wert von 10 A eingestellt. Um nun die eigentliche erfindungsgemäße Einstellung zu starten, ist es vorzugsweise vorgesehen, einen Einstellmodus zu aktivieren. Dies kann beispielsweise auch durch Betätigung vorgenannten Bestätigungsmittels (8) erfolgen. Dabei kann das Rückmeldesignalmittel (7) dem Benutzer über eine dritte Signalform signalisieren, dass der Einstellmodus aktiviert ist. Im Einstellmodus wird der zuvor eingestellte Maximalwert für den Auslösestrom für die Auslösung des Schutzschalters (4) solange verwendet, bis der neu ausgewählte, optimierte Auslösestrom als Sollwert für den Auslösestrom zur Verwendung im Arbeitsmodus bestätigt wird. Bei Bestätigung des ausgewählten Auslösestroms zeigt das Rückmeldesignalmittel (7) über die dritte Signalform wieder den Arbeitsmodus an. Im Einstellmodus wird der jeweils eingestellte Auslösestrom mit dem aktuell fließenden Strom verglichen und über das Rückmeldesignalmittel (7) dem Benutzer eine Rückmeldung über den Vergleich zur Auswahl des optimalen Auslösestroms gegeben. Im "Hintergrund" ist jedoch der vor Beginn des Einstellmodus eingestellte Auslösestrom für die Auslösung des Schutzschalters (4) relevant, bis der neue Auslösestrom bestätigt wird.

Da der gemessene Strom mit 3A kleiner ist als 80% des eingestellten Auslösestroms von 10 A, d.h. 3A < 0,8 x 10A, gibt das Rückmeldesignalmittel (7) eine Rückmeldung mit der ersten Signalform. Daraufhin wird der Benutzer den Auslösestrom über das Einstellmittel (6) auf die nächst niedrigere Stufe (6A) erniedrigen. Dabei wird die Signalform des Rückmeldesignalmittels (7) sich nicht ändern, da der gemessene Strom immer noch kleiner ist als 80% des jetzt eingestellten Auslösestroms. Daraufhin wird der Benutzer erneut den Auslösestrom auf die nächst niedrigere Stufe (4A) erniedrigen. Auch dies führt noch nicht zu einer Änderung der Signalform, da 3A < 0,8 x 4A. Erst die nächste Erniedrigung des Auslösestroms auf 2A führt zu einem Wechsel der Signalform, nämlich von der ersten Signalform zur zweiten Signalform, da jetzt der gemessene Strom von 3A größer ist als 80% des eingestellten Auslösestrom, d.h. 3 A > 0,8 x 2A. Dieser Wechsel in der Signalform zeigt dem Benutzer an, dass der zuvor eingestellte Wert (4A) der optimale Wert für den Auslösestrom im Arbeitsmodus der Schutzanordnung (1) ist. Um diesen Wert als Sollwert für den Arbeitsmodus auszuwählen, wird der Benutzer über das Einstellmittel (6) ausgehend von der Stufe 2A den Auslösestrom wieder die nächste Stufe (4A) erhöhen, wobei das Ergebnis wiederum durch einen Signalformwechsel angezeigt wird.

Somit ist die Auslösung des Schutzschalters (4) einerseits hinreichend empfindlich, um das angeschlossene Gerät (2) sicher zu schützen und andererseits nicht zu empfindlich, um in unkritischen Fällen Fehlabschaltungen zu vermeiden. Dabei entspricht der während der Einstellung fließende und gemessene Strom (hier 3A) typischerweise zumindest ca. dem Nennstrom des Geräts (2). Über das Einstellmittel (6) und den angezeigten Signalformwechsel kann der Benutzer sich in einfacher Weise dem Nennstrom des zu schützenden Geräts (2) nähern und den Auslösestrom auf einen Wert einstellen, der um eine Toleranz-Differenz $\Delta\mathcal{I}$ größer ist als der Nennstrom. In einer bevorzugten Ausführungsform hat der Benutzer noch die Möglichkeit, den optimalen Auslösestrom durch ein Bestätigungsmittel (8) zur weiteren Verwendung im Arbeitsmodus der Schutzanordnung (1) zu bestätigen.

Im vorliegenden Fall wäre eine Auslösestrom von 6A oder gar 10A viel zu hoch, um das Gerät (2) mit einem Nennstrom von 3A sicher zu schützen, wohingegen beim erfindungsgemäß eingestellten Auslösestromwert von 4A einerseits ein zuverlässiger Schutz vor Überstrom gegeben ist, während andererseits relativ geringfügige Schwankungen in der Stromaufnahme des Geräts (2) nicht zu unerwünschten Fehlauslösungen des Schutzschalters (4) führen.

Wie in Figur 3 dargestellt, weist die Schutzanordnung eine Auswerte- und Steuereinheit (9) auf, welcher der gemessene Strom ($\mathcal{I}$Ist) und ein Signal des Einstellmittels (6) zugeführt wird, wobei die Auswerte- und Steuereinheit (9) anhand des gemessenen Stroms ($\mathcal{I}$Ist) und des Signals des Einstellmittels (6), d.h. durch einen Vergleich des gemessen Stroms mit dem jeweils eingestellten Auslösestrom, das Rückmeldesignalmittel (7) ansteuert.

Als Rückmeldesignalmittel (7) wird vorzugsweise ein optisches Rückmeldesignalmittel (7) verwendet. Dabei ist die erste und/oder die zweite Signalform durch

a) ein Blinken oder ein Dauerleuchten, und/oder

b) eine Farbe, und/oder

c) eine Helligkeit

charakterisiert, wobei die erste oder die zweite Signalform sich in wenigstens einem der vorstehend genannten Charakteristika unterscheidet.

Als optisches Rückmeldesignalmittel (7) wird vorzugsweise eine LED verwendet, die bei entsprechender Ansteuerung sowohl Blinken als auch Dauerleuchten sowie in mindestens zwei verschiedenen Farben leuchten kann.

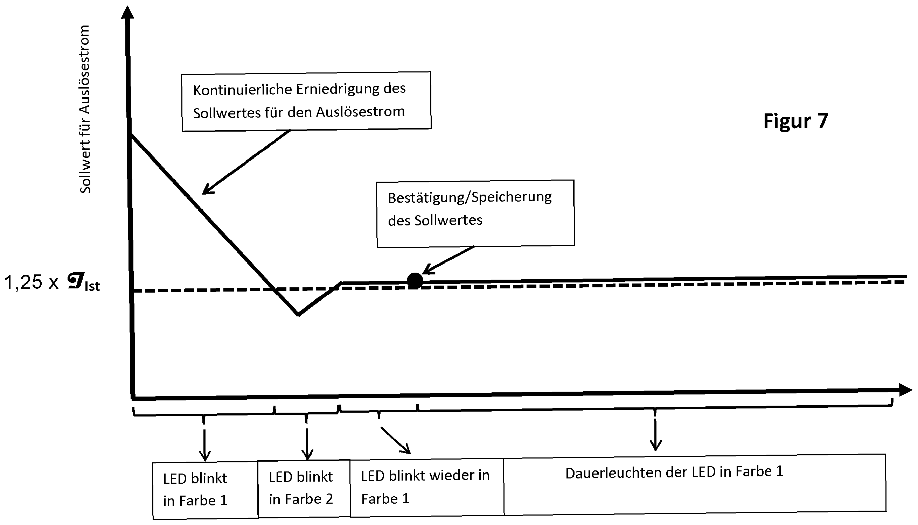

Wie in Figur 7 veranschaulicht, leuchtet die LED in einer ersten Farbe 1, um die erste Signalform anzuzeigen, bei der der gemessene Strom kleiner als Auslösestrom (ggf. kleiner als der mit einem Faktor kleiner 1 multiplizierte Auslösestrom) ist, während die LED in einer zweiten Farbe leuchtet, um die zweite Signalform anzuzeigen, wenn der gemessene Strom größer als der Auslösestrom (ggf. größer als der mit einem Faktor kleiner 1 multiplizierte Auslösestrom) ist.

Die Charakteristika "Blinken" bzw. "Dauerleuchten" werden verwendet, um als dritte Signalform anzuzeigen, ob die Schutzanordnung sich im Einstellmodus befindet.

Die erste und die zweite Signalform können sich im Blink-Betrieb der LED (7) auch darin unterscheiden, dass die LED (7) in der ersten Signalform nur in Farbe 1 blinkt, während sie in der zweiten Signalform alternierend in Farbe 1 und Farbe 2 blinkt.

Alternativ zum optischen ist auch ein akustisches Rückmeldesignalmittel (7) vorgesehen. Dabei ist die erste und/oder die zweite Signalform durch

a) eine wiederkehrende Folge von Tonpulsen oder einen Dauerton, und/oder

b) eine Tonhöhe, und/oder

c) eine Lautstärke

charakterisiert.

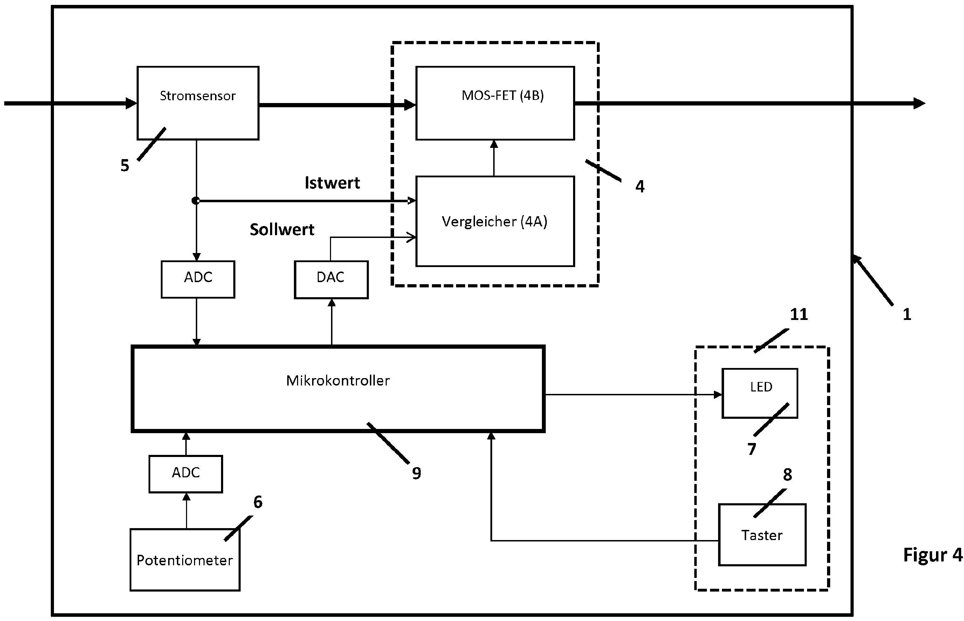

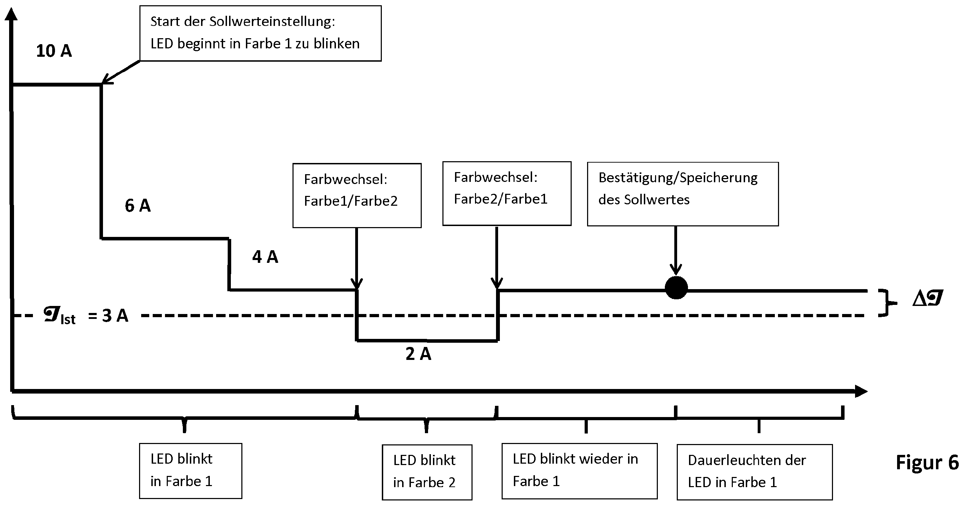

In Figur 4 ist eine Schutzanordnung (1) dargestellt, bei der als Auswerte- und Steuereinheit (9) ein Mikrokontroller, als optisches Rückmeldesignalmittel (7) eine LED sowie als Einstellmittel (6) für den Auslösestrom ein Potentiometer verwendet wird. Als Schutzschalter (4) wird insbesondere ein elektronischer Schalter (4B), vorzugsweise ein Transistor in Form eines MOS-FET, verwendet, der über einen Vergleicher (4A) angesteuert wird. Als Potentiometer (6) kann ein stufenweise einstellbares Potentiometer (siehe Fig. 6) oder ein stufenlos einstellbares Potentiometer (siehe Fig. 7) verwendet werden.

Dabei wird das analoge Mess-Signal des Stromsensors (5) über einen Analog-Digital-Converter (ADC) in ein digitales Signal gewandelt und dann dem Mikrokontroller (9) zugeführt. Ebenso wird das analoge Signal des Potentiometers (6) über einen ADC dem Mikrokontroller als digitales Signal zugeführt. Innerhalb des Mikrokontrollers (9) findet nun ein Vergleich des gemessenen Stroms ($\mathcal{J}$Ist) mit dem über das Potentiometer (6) eingestellten Auslösestrom statt. Entsprechend des Vergleichsergebnisses steuert der Mikrokontroller (9) dann die LED (7) an, um über die verschiedenen Signalformen ("Blinken in Farbe 1", Blinken in Farbe 2", "Dauerleuchten in Farbe 1") eine Rückmeldung an den Benutzer zu geben.

Falls über die manuelle Einstellung und die optische Rückmeldung der optimale Auslösestrom ermittelt wurde, wird dieser vom Benutzer über ein als Taster ausgebildetes Betätigungsmittel (8) bestätigt. Dies kann bspw. durch Drücken des Tasters (8) für eine vorbestimmte Zeit (z.B. 1 s) erfolgen. Das Signal des Tasters (8) wird wiederum dem Mikrokontroller (9) zugeführt, der bei Betätigung des Tasters (8) anhand des aktuellen Wertes des Potentiometers (6) den Sollwert für den Auslösestrom bestimmt.

Dem Vergleicher (4A) sind eingangsseitig der gemessene Strom ($\mathcal{J}$Ist) als Istwert sowie der Auslösestrom als Sollwert zugeführt, wobei der Sollwert anhand eines Signals vom Mikrokontroller erzeugt und über einen Digital-Analog-Converter dem Vergleicher (4A) zugeführt wird. Ausgangsseitig steuert der Vergleicher (4A) den Schalter (4B) derart an, dass wenn der gemessene Strom den Auslösestrom überschreitet, der Schalter (4B) öffnet und die Stromleitung unterbricht.

Figur 7 veranschaulicht die Sollwerteinstellung für den Auslösestrom - ähnlich wie in Figur 6 - jedoch unter Verwendung eines Einstellmittels (6) für den Auslösestrom, das eine stufenlose Einstellung, d.h. Erniedrigung und Erhöhung, ermöglicht.

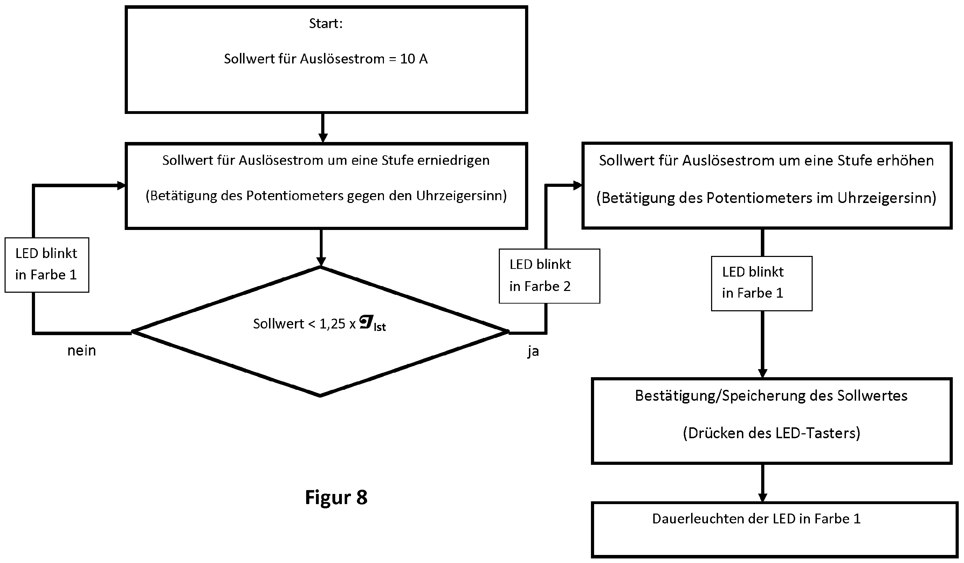

Fig. 8 zeigt ein Flussdiagramm zur Veranschaulichung der Einstellung des Auslösestroms.

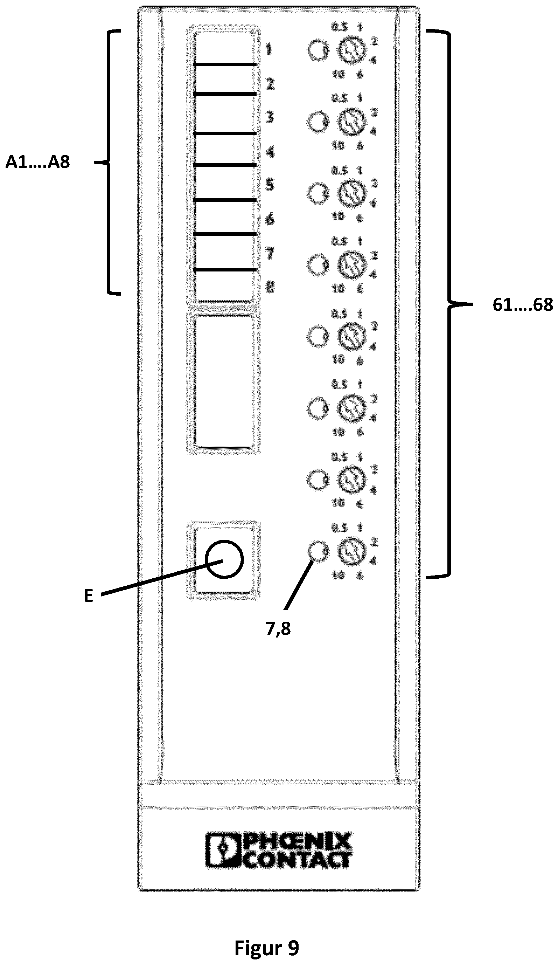

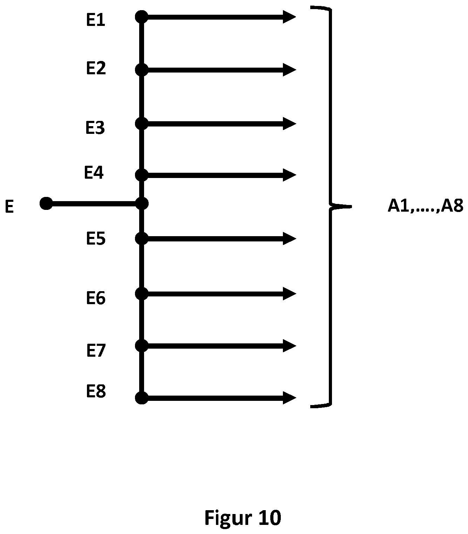

Fig. 9 zeigt eine Draufsicht auf eine Frontblende einer erfindungsgemäßen Schutzanordnung (1). Diese Schutzanordnung (1) ist zur Versorgung und zum Schutz von mehreren, beispielsweise 8, Geräten ausgebildet, wozu die Schutzanordnung (1) 8 Kanäle mit 8 Stromausgängen (A1, ...., A8) aufweist. Jedem Kanal ist dabei ein Stromsensor, ein Potentiometer (61, ..., 68) zur Einstellung des Auslösestroms sowie eine LED (7) und ein Taster (8) zugeordnet, wobei LED (7) und Taster (8) jeweils als eine Baueinheit ausgebildet sind. Die Betätigung des Tasters (8) erfolgt dabei über ein Drücken der LED (7). Vorzugsweise teilen sich die 8 Kanäle eine Auswerte- und Steuereinheit. Der Schutzanordnung (1) wird an einem zentralen Eingang (E) ein Sammelstrom zugeführt, der dann auf die Eingänge (E1,..., E8) für die einzelnen Kanäle aufgeteilt wird (siehe Figur 10).

**Bezugszeichenliste**

| | |
|---|---|
| 1 | Schutzanordnung |
| 2 | zu schützendes elektrisches Gerät |
| 3 | Stromversorgung |

| 4 | Schutzschalter |
|---|---|
| 4A | Vergleicher |
| 4B | MOSFET |
| 5 | Stromsensor |
| 6, 61, ..., 68 | Einstellmittel |
| 7 | Rückmeldesignalmittel |
| 8 | Bestätigungsmittel |
| 9 | Auswerte- und Steuereinheit |
| 10 | Baueinheit aus Schutzanordnung und Stromversorgung |
| 11 | Baueinheit aus Rückmeldesignalmittel und Bestätigungsmittel |
| E, E1,...., E8 | Eingänge |
| A, A1,..., A8 | Ausgänge |

**Patentansprüche**

1. Schutzanordnung (1) zum Schutz von elektrischen Geräten (2) vor Überstrom, wobei

- die Schutzanordnung (1) einen Eingang (E, E1,.., E8) aufweist, an dem der Schutzanordnung (1) von einer Stromversorgung ein Strom (I) zugeführt wird,
- die Schutzanordnung (1) einen Ausgang (A, A1,..., A8) aufweist, über den der Strom (I) als Ausgangsstrom an das elektrische Gerät (2) weitergeleitet wird,
- die Schutzanordnung (1) in der Stromleitung zwischen dem Eingang (E, E1,.., E8) und dem Ausgang (A, A1,..., A8) einen Schutzschalter (4) aufweist, der beim Überschreiten eines eingestellten Auslösestroms durch einen gemessenen Strom ($I_{Ist}$), die Stromleitung unterbricht,

wobei die Schutzanordnung (1) einen Stromsensor (5) aufweist, der den Strom ($I_{Ist}$) in der Stromleitung bei angeschlossenem Gerät (2) misst, wobei der Auslösestrom in Abhängigkeit vom gemessenen Strom ($I_{Ist}$) auf einen Wert einstellbar ist, der um eine vorgegebene Differenz ($\Delta I$) größer ist als der gemessene Strom ($I_{Ist}$) und die Schutzanordnung (1) ein manuelles Einstellmittel (6) aufweist, um den Auslösestrom zwischen einem oberen und einem unteren Wert stufenweise oder stufenlos zu erniedrigen oder zu erhöhen, **dadurch gekennzeichnet, dass** die Schutzanordnung (1) ein optisches und/oder akustisches Rückmeldesignalmittel (7) aufweist, das dem Benutzter mit einer ersten Signalform eine Rückmeldung darüber gibt, ob ein anhand des jeweils eingestellten Wertes für den Auslösestrom bestimmter Schwellwert größer ist als der gemessene Strom ($I_{Ist}$), während es dem Benutzer mit einer zweiten, von der ersten verschiedenen Signalform eine Rückmeldung darüber gibt, ob der anhand des jeweils eingestellten Wertes für den Auslösestrom bestimmte Schwellwert kleiner ist als der gemessene Strom ($I_{Ist}$).

2. Schutzanordnung nach Anspruch 1, **dadurch gekennzeichnet, dass** dieselbe eine Auswerte- und Steuereinheit (9) aufweist, der der gemessene Strom ($I_{Ist}$) zugeführt wird, wobei die Auswerte-und Steuereinheit anhand des gemessenen Stroms ($I_{Ist}$) automatisch den Wert für den Auslösestrom einstellt.

3. Schutzanordnung nach Anspruch 1, **dadurch gekennzeichnet, dass** die Schutzanordnung ein Betätigungsmittel aufweist, um einen Einstellmodus für den Auslösestrom zu aktivieren.

4. Schutzanordnung nach Anspruch 3, **dadurch gekennzeichnet, dass** die Schutzanordnung (1) ein Bestätigungsmittel (8) ausweist, über das ein ausgewählter Wert für den Auslösestrom zur Verwendung im Arbeitsmodus vom Benutzer bestätigbar ist.

5. Schutzanordnung nach Anspruch 3 oder 4, wobei dieselbe ein optisches Rückmeldesignalmittel (7) aufweist, **dadurch gekennzeichnet, dass** die erste und/oder die zweite Signalform durch

a) ein Blinken oder ein Dauerleuchten, und/oder
b) eine Farbe, und/oder
c) eine Helligkeit

charakterisiert ist, wobei die erste und die zweite Signalform sich in wenigstens einem der vorstehend genannten Charakteristika voneinander unterscheiden.

6. Schutzanordnung nach Anspruch 3 oder 4, wobei dieselbe ein akustisches Rückmeldesignalmittel (7) aufweist, **dadurch gekennzeichnet, dass** die erste und/oder die zweite Signalform durch

a) eine wiederkehrende Folge von Tonpulsen oder einen Dauerton, und/oder
b) eine Tonhöhe, und/oder
c) eine Lautstärke

charakterisiert ist, wobei die erste und die zweite Signalform sich in wenigstens einem der vorstehend genannten Charakteristika voneinander unterscheiden.

7. Schutzanordnung nach einem der Ansprüche 3 bis 6,
   **dadurch gekennzeichnet, dass** das Rückmeldesignalmittel (7) mit einer dritten Signalform eine Rückmeldung darüber gibt, ob die Schutzanordnung (1) sich im Einstellmodus oder im Arbeitsmodus befindet.

8. Schutzanordnung nach einem der vorstehenden Ansprüche 3 bis 7, **dadurch gekennzeichnet, dass** dieselbe eine Auswerte- und Steuereinheit (9) aufweist, der der gemessene Strom ($\mathcal{I}$Ist) und ein Signal des Einstellmittels (6) zugeführt wird, wobei die Auswerte- und Steuereinheit (9) anhand des gemessenen Stroms ($\mathcal{I}$Ist) und des Signals des Einstellmittels (6) das Rückmeldesignalmittel (7) ansteuert.

9. Schutzanordnung nach Anspruch 8,
   **dadurch gekennzeichnet, dass**
   der Auswerte- und Steuereinheit (9) ein Signal des Bestätigungsmittels (8) zugeführt wird, wobei bei Erhalt des Bestätigungssignals der ausgewählte Wert für den Auslösestrom zur Verwendung im Arbeitsmodus in der Auswerte- und Steuereinheit (9) abgespeichert wird.

10. Schutzanordnung nach einem der vorstehenden Ansprüche,
    **dadurch gekennzeichnet, dass**
    der Schutzschalter (4A) einen Transistor, aufweist, der von einem Vergleicher (4B) angesteuert wird, wobei dem Vergleicher (4B) als Eingangssignal einerseits der gemessene Strom ($\mathcal{I}$Ist) als Istwert und andererseits und der eingestellte Auslösestrom als Sollwert zugeführt wird, wobei der Ausgang des Vergleichers den Schalter (4A) derart ansteuert, dass dieser die Stromleitung unterbricht, wenn der Istwert größer als der Sollwert ist.

11. Schutzanordnung nach einem der vorstehenden Ansprüche 3 bis 10,
    **dadurch gekennzeichnet, dass**
    das Einstellmittel (6) ein Potentiometer ist.

12. Schutzanordnung nach einem der vorstehenden Ansprüche 3 bis 11,
    **dadurch gekennzeichnet, dass**
    das Rückmeldesignalmittel (7) eine LED ist.

13. Schutzanordnung nach einem der vorstehenden Ansprüche 3 bis 12,
    **dadurch gekennzeichnet, dass**
    das Betätigungsmitte und/oder das Bestätigungsmittel (8) ein Taster ist.

14. Schutzanordnung nach Anspruch 12 und 13,
    **dadurch gekennzeichnet, dass**
    die LED (7) und der Taster (8) in einer Baueinheit integriert sind.

## Claims

1. Protective arrangement (1) for protecting electrical devices (2) from overcurrent, wherein

   - the protective arrangement (1) comprises an input (E, E1,.., E8) at which the protective arrangement (1) is supplied with a current (I) from a power supply,
   - the protective arrangement (1) comprises an output (A, A1,..., A8) via which the current (I) is passed on to the electrical device (2) as output current,
   - the protective arrangement (1) comprises a circuit breaker (4) in a power line between the input (E, E1,.., E8) and the output (A, A1,..., A8) which interrupts the power line when a set tripping current is exceeded by a measured current ($\mathcal{I}$Ist),

   wherein the protective arrangement (1) comprises a current sensor (5) which measures the current ($\mathcal{I}$Ist) in the power line when the device (2) is connected, wherein the tripping current is adjustable on the basis of the measured current ($\mathcal{I}$Ist) to a value that is greater than the measured current ($\mathcal{I}$Ist) by a predefined difference ($\Delta\mathcal{I}$) and wherein the protective arrangement (1) comprises manual setting means (6) in order to reduce or increase the tripping current stepwise or steplessly between an upper and a lower value, **characterized in that** the protective arrangement (1) comprises optical and/or acoustic feedback signal means (7) which gives the user feedback with a first signal form as to whether a threshold value determined on the basis of the respective value set for the tripping current is greater than the measured current ($\mathcal{I}$Ist), while a second signal form that is different from the first signal form provides the user feedback as to whether the threshold value determined on the basis of the respective value set for the tripping current is lower than the measured current ($\mathcal{I}$Ist).

2. Protective arrangement according to claim 1,
   **characterized by**
   comprising an evaluation and control unit (9) to which the measured current ($\mathcal{I}$Ist) is fed, wherein the evaluation and control unit automatically sets the value for the tripping current on the basis of the measured current ($\mathcal{I}$Ist).

3. Protective arrangement according to claim 1, **characterized in that** the protective arrangement comprises actuating means in order to activate a setting mode for the tripping current.

4. Protective arrangement according to claim 3, **characterized in that** the protective arrangement (1) comprises confirmation means (8) by means of which a selected value for the tripping current for use in a working mode can be confirmed by the user.

5. Protective arrangement according to claim 3 or 4, comprising optical feedback signal means (7), **characterized in that** the first and/or the second signal form is **characterized by**

   a) a flashing or a continuous lighting, and/or
   b) a color, and/or
   c) a brightness,

   wherein the first and the second signal form differ from one another in at least one of the aforementioned characteristics.

6. Protective arrangement according to claim 3 or 4, comprising acoustic feedback signal means (7), **characterized in that** the first and/or the second signal form is **characterized by**

   a) a recurring sequence of tone pulses or a continuous tone, and/or
   b) a tone pitch, and/or
   c) a volume,

   wherein the first and the second signal form differ from one another in at least one of the aforementioned characteristics.

7. Protective arrangement according to one of claims 3 to 6, **characterized in that** the feedback signal means (7) provides feedback with a third signal form as to whether the protective arrangement (1) is in the setting mode or in the working mode.

8. Protective arrangement according to one of the preceding claims 3 to 7, **characterized by** comprising an evaluation and control unit (9) to which the measured current ($\mathcal{I}$Ist) and a signal from the setting means (6) are fed, wherein the evaluation and control unit (9) controls the feedback signal means (7) on the basis of the measured current ($\mathcal{I}$Ist) and the signal from the setting means (6).

9. Protective arrangement according to claim 8, **characterized in that** the evaluation and control unit (9) is supplied with a signal from the confirmation means (8), wherein the selected value for the tripping current is stored in the evaluation and control unit (9) for use in the working mode when the confirmation signal is received.

10. Protective arrangement according to one of the preceding claims, **characterized in that** the circuit breaker (4A) comprises a transistor which is controlled by a comparator (4B), wherein the comparator (4B) is supplied, as an input signal, on the one hand the measured current ($\mathcal{I}$Ist) as the actual value and on the other hand the set tripping current as a setpoint value, the output of the comparator controlling the switch (4A) in such a way that it interrupts the power line when the actual value is greater than the setpoint value.

11. Protective arrangement according to one of the preceding claims 3 to 10, **characterized in that** the setting means (6) is a potentiometer.

12. Protective arrangement according to one of the preceding claims 3 to 11, **characterized in that** the feedback signal means (7) is an LED.

13. Protective arrangement according to one of the preceding claims 3 to 12, **characterized in that** the actuation means and/or the confirmation means (8) is a button.

14. Protective arrangement according to claim 12 and 13, **characterized in that** the LED (7) and the button (8) are integrated in one unit.

**Revendications**

1. Dispositif de protection (1) destiné à la protection d'appareils électriques (2) contre des surintensités, dans lequel

   - le dispositif de protection (1) comporte une entrée (E, E1, ..., E8) par laquelle un courant (I) est introduit dans le dispositif de protection (1) par une alimentation électrique,
- le dispositif de protection (1) comporte une sortie (A, A1, ..., A8) par l'intermédiaire de laquelle le courant (I) est transmis en tant que courant de sortie à l'appareil électrique (2),
- le dispositif de protection (1) comporte dans la ligne de courant entre l'entrée (E, E1, ..., E8) et la sortie (A, A1, ..., A8) un disjoncteur (4) qui, en cas de dépassement d'une intensité de déclenchement réglée par une intensité mesurée ($I_{st}$), interrompt la ligne de courant,

dans lequel le dispositif de protection (1) comporte un capteur de courant (5) qui mesure l'intensité ($I_{st}$) dans la ligne de courant lorsque l'appareil (2) est raccordé, dans lequel l'intensité de déclenchement peut être réglée en fonction de l'intensité mesurée ($I_{st}$) à une valeur qui est supérieure à l'intensité mesurée ($I_{st}$) d'une différence prédéfinie ($\triangle I$) et le dispositif de protection (1) comporte des moyens de réglage manuels (6) permettant de diminuer ou d'augmenter l'intensité de déclenchement par paliers ou de manière continue entre une valeur supérieure et une valeur inférieure, **caractérisé en ce que**
le dispositif de protection (1) comporte un moyen générateur de signal de retour optique et/ou acoustique (7) qui fournit à l'utilisateur un retour sous la forme d'une première forme de signal indiquant si une valeur de seuil déterminée sur la base de la valeur respectivement réglée pour l'intensité de déclenchement est supérieure à l'intensité mesurée ($I_{st}$), tandis qu'il fournit à l'utilisateur un second type de signal, différent du premier, pour indiquer si la valeur de seuil déterminée sur la base de la valeur réglée pour l'intensité de déclenchement est inférieure à l'intensité mesurée ($I_{st}$).

2. Dispositif de protection selon la revendication 1, **caractérisé en ce que**
celui-ci comporte une unité d'évaluation et de commande (9) à laquelle est fournie l'intensité mesurée ($I_{st}$), dans lequel l'unité d'évaluation et de commande règle automatiquement la valeur de l'intensité de déclenchement sur la base de l'intensité mesurée ($I_{st}$).

3. Dispositif de protection selon la revendication 1, **caractérisé en ce que**
le dispositif de protection comporte un moyen d'actionnement permettant d'activer un mode de réglage de l'intensité de déclenchement.

4. Dispositif de protection selon la revendication 3, **caractérisé en ce que**
le dispositif de protection (1) comporte un moyen de confirmation (8) par l'intermédiaire duquel une valeur sélectionnée de l'intensité de déclenchement à utiliser dans le mode de fonctionnement peut être confirmée par l'utilisateur.

5. Dispositif de protection selon la revendication 3 ou 4, dans lequel celui-ci comporte un moyen générateur de signal de retour optique (7), **caractérisé en ce que** la première et/ou la deuxième forme de signal est/sont **caractérisée**(s) par

    a) un témoin lumineux clignotant ou fixe, et/ou
    b) une couleur, et/ou
    c) une luminosité,

dans lequel les première et deuxième formes de signal diffèrent l'une de l'autre par au moins l'une des caractéristiques mentionnées ci-dessus.

6. Dispositif de protection selon la revendication 3 ou 4, dans lequel celui-ci comporte un moyen générateur de signal de retour acoustique (7), **caractérisé en ce que** la première et/ou la deuxième forme de signal est/sont **caractérisée**(s) par

    a) une séquence répétitive d'impulsions sonores ou un son continu, et/ou
    b) une hauteur de son, et/ou
    c) une intensité sonore,

dans lequel les première et deuxième formes de signal diffèrent l'une de l'autre par au moins l'une des caractéristiques mentionnées ci-dessus.

7. Dispositif de protection selon l'une des revendications 3 à 6, **caractérisé en ce que** le moyen générateur de signal de retour (7) fournit un retour au moyen d'une troisième forme de signal indiquant si le dispositif de protection (1) se trouve dans le mode de réglage ou dans le mode de fonctionnement.

8. Dispositif de protection selon l'une des revendications 3 à 7 précédentes, **caractérisé en ce que** celui-ci comporte une unité d'évaluation et de commande (9) à laquelle sont fournis l'intensité mesurée ($I_{st}$) et un signal du moyen de réglage (6), dans lequel l'unité d'évaluation et de commande (9) commande le moyen générateur de signal de retour (7) sur la base de l'intensité mesurée ($I_{st}$) et du signal du moyen de réglage (6).

9. Dispositif de protection selon la revendication 8, **caractérisé en ce que**
l'unité d'évaluation et de commande (9) reçoit un signal du moyen de confirmation (8), dans lequel, lors de l'obtention du signal de confirmation, la valeur sélectionnée de l'intensité de déclenchement est stockée dans l'unité d'évaluation et de commande (9) pour être utilisée dans le mode de fonctionnement.

10. Dispositif de protection selon l'une des revendications précédentes, **caractérisé en ce que** le disjoncteur (4A) comporte un transistor qui est commandé par un comparateur (4B), dans lequel le comparateur (4B) reçoit en tant que signal d'entrée, d'une part, l'intensité mesurée ($I_{Ist}$) en tant que valeur réelle et d'autre part, l'intensité de déclenchement réglée en tant que valeur de consigne, dans lequel la sortie du comparateur commande le commutateur (4A) de telle manière que celui-ci interrompe la ligne de courant lorsque la valeur réelle est supérieure à la valeur de consigne.

11. Dispositif de protection selon l'une des revendications 3 à 10 précédentes, **caractérisé en ce que** le moyen de réglage (6) est un potentiomètre.

12. Dispositif de protection selon l'une des revendications 3 à 11 précédentes, **caractérisé en ce que** le moyen générateur de signal de retour (7) est une LED.

13. Dispositif de protection selon l'une des revendications 3 à 12 précédentes, **caractérisé en ce que** le moyen d'actionnement et/ou le moyen de confirmation (8) est un bouton poussoir.

14. Dispositif de protection selon les revendications 12 et 13, **caractérisé en ce que**
la LED (7) et le bouton poussoir (8) sont intégrés dans une même unité.

**Figur 1**

Figur 2

E

A

Stromsensor

5

9

Schutzschalter

4

Auswerte- u. Steuereinheit

9

1

EP 3 275 065 B1

12

Figur 3

**Figur 4**

**Start der Sollwert-Einstellung für den Auslösestrom**
Auswahl des maximalen Auslösestroms

10 A — $\mathcal{I}_{Ist} < 0{,}8x\ 10A$

Auswahl der nächst niedrigen
Auslösestroms

6 A — $\mathcal{I}_{Ist} < 0{,}8x\ 6A$

Zurück zum letzten Wert
Bestätigung mittels des Tasters
Abspeicherung als Sollwert

Auswahl der nächst niedrigen
Auslösestroms

4 A — $\mathcal{I}_{Ist} < 0{,}8 \times 4A$

$\Delta\mathcal{I}$

$\mathcal{I}_{Ist} = 3A$

Auswahl der nächst niedrigen
Auslösestroms

2 A — $\mathcal{I}_{Ist} > 0{,}8 \times 2A$

1 A

0,5 A

**Figur 5**

Figur 6

Figur 7

Kontinuierliche Erniedrigung des Sollwertes für den Auslösestrom

Bestätigung/Speicherung des Sollwertes

$1{,}25 \times \mathcal{I}_{Ist}$

Sollwert für Auslösestrom

LED blinkt in Farbe 1

LED blinkt in Farbe 2

LED blinkt wieder in Farbe 1

Dauerleuchten der LED in Farbe 1

EP 3 275 065 B1

EP 3 275 065 B1

Start:

Sollwert für Auslösestrom = 10 A

Sollwert für Auslösestrom um eine Stufe erniedrigen

(Betätigung des Potentiometers gegen den Uhrzeigersinn)

Sollwert für Auslösestrom um eine Stufe erhöhen

(Betätigung des Potentiometers im Uhrzeigersinn)

LED blinkt
in Farbe 1

LED blinkt
in Farbe 2

LED blinkt
in Farbe 1

Sollwert < 1,25 x $\mathcal{I}_{Ist}$

nein

ja

Bestätigung/Speicherung des Sollwertes

(Drücken des LED-Tasters)

Dauerleuchten der LED in Farbe 1

**Figur 8**

**Figur 9**

E1

E2

E3

E4

E

E5

E6

E7

E8

A1,….,A8

**Figur 10**

**IN DER BESCHREIBUNG AUFGEFÜHRTE DOKUMENTE**

**In der Beschreibung aufgeführte Patentdokumente**

- DE 202004014589 U1
- US 20130066478 A1
- DE 102007013551 A1
- DE 19811956 A1